# EUROPEAN PATENT APPLICATION

(11) **EP 3 007 220 A1**
(43) Date of publication of application: **13.04.2016**
(21) Application number: 14188427.0
(22) Date of filing: 10.10.2014
(51) Int. Cl.: H01L 23/051, H01L 23/16

(54) **Power semiconductor device having protection against explosion or rupture**

(71) Applicant: ABB Technology AG, 8050 Zürich (CH)
(72) Inventor: Mohn, Fabian, 5408 Ennetbaden (CH); Liu, Chunlei, 5406 Rütihof (CH); Commin, Paul, 8006 Zürich (CH)
(74) Representative: ABB Patent Attorneys

(57) **Abstract**

The present invention relates to a power semiconductor device (10), comprising a power semiconductor element (12) with an upper side (14) and with a lower side (16), the upper side (14) being located opposite to the lower side (16); a first electrode (18) and a second electrode (20), wherein the power semiconductor element (12) is arranged between the first electrode (18) and the second electrode (20) such, that the upper side (14) is in electrical contact to the first electrode (18), and that the lower side (16) is in electrical contact to the second electrode (20), and wherein a housing arrangement (26) is provided at least comprising the first electrode (18), the second electrode (20) and an electrical insulator (28), wherein at least one safety element (34) comprising a porous material is provided inside the housing arrangement (26). A power semiconductor device (10) according to the present invention may provide an improved capability against a rupture of the housing arrangement (26).

## Description

### Technical Field

The present invention relates to power semiconductor devices. The present invention particularly refers to power semiconductor devices having improved failure behaviour.

### Background Art

Bipolar power semiconductor devices such as thyristors and diodes are commonly used in hermetically sealed press-pack housings for use in high-power converter applications such as high-current rectifiers and motor drives or medium-voltage drives. In such applications, fault situations can occur in which a device loses its blocking capability and is subject to an excessive fault current in the reverse direction. This fault current can lead to evaporation of the silicon in the defective device region and arcing across the resulting gap between the anode and cathode contacts. The high temperature of the electric arc, such as of approximately 20,000°C, and the pressure increase caused by evaporation of silicon and metal at the arc roots, or other surrounding materials, can cause significant damage to the interior of the press-pack housings used for bipolar semiconductor devices.

If the energy released in the arc is sufficiently high, the structural integrity of the housing may be compromised by the arc plasma burning through the thin metal flanges of the housing, or by cracking of the ceramic insulating part of the housing. In both cases, a release of the hot plasma to the environment will occur, which can cause damage to the surrounding equipment. The situation may be avoided by using fast-enough fuses to protect the semiconductor and a housing design that will not rupture under the expected short-circuit current integral.

Known from DE 30 32 133 C2 is a semiconductor device which is described to have improved resistance against explosions. Such a semiconductor device comprises a safety element which is formed in a multi-part form, wherein the different parts comprise a defined movability.

DE 8909244 describes a semiconductor element, especially for power electronics. Such an element is provided in a housing. In order to provide improved safety, this document teaches to provide a solid material in a granular form inside the housing.

Document DE 103 06 767 A1 describes a semiconductor module. In order to improve the safety of a housing with regard to arcs occurring at an overload, an insulator is provided at least partly between the housing and the semiconductor element.

There is, however, still potential to improve a failure mode and especially the resistance against rupture in a power semiconductor device.

### Disclosure of Invention

It is an object of the present invention to provide a power semiconductor device which may prevent at least one disadvantage of the prior art at least partly. It is particularly an object of the present invention to provide a power semiconductor device which reduces the danger of significant destructions caused by a failure.

These objects are at least partly solved by a power semiconductor device according to independent claim 1. Advantageous embodiments are given in the dependent claims.

In particular, the present invention provides a power semiconductor device, comprising a power semiconductor element with an upper side and with a lower side, the upper side being located opposite to the lower side;
a first electrode and a second electrode, wherein the power semiconductor element is arranged between the first electrode and the second electrode such, that the upper side is in electrical contact to the first electrode, and that the lower side is in electrical contact to the second electrode, and wherein a housing arrangement is provided at least comprising the first electrode, the second electrode and an electrical insulator, wherein at least one safety element comprising a porous material is provided inside the housing arrangement.

A power semiconductor device like described above provides an improved failure mode. In particular, the power semiconductor device like described above may significantly reduce the danger of an explosion occurring due to an overpressure created inside the housing in case of a failure and thus provides an improved solution that prevents explosive rupturing of the device at current integrals in particular beyond what is currently possible.

A power semiconductor device according to the present invention shall particularly be a device which is based on a semiconductor element and which may preferably be used as a switch or rectifier in power electronics. Non-limiting examples for power semiconductor devices comprise inter alia gate turn-off thyristors (GTO), insulated gate bipolar transistors (IGBT) and according to the invention particularly preferred diodes, thyristors and especially those who are at least partly encapsulated in housings having an insulating ring, such as a ceramic ring, surrounding the power semiconductor element.

The power semiconductor device comprises a power semiconductor element with an upper side and with a lower side, the upper side being located opposite to the lower side. Such a power semiconductor device is widely known in the art and may be formed as appropriate for the specific application. In detail and for the non-limiting example of a thyristor, the semiconductor element may be formed of a semiconductor, such as silicon, which comprises alternating layers (P-N-P-N). Such structures, or such semiconductor devices, respectively, are generally known in the art and will thus not be described in detail.

The power semiconductor device further comprises a first electrode and a second electrode. These electrodes may serve as anode and cathode generally be formed from a material as it is known in the art. For example, the electrodes may be formed from copper. The first electrode is arranged in vicinity to the upper side of the semiconductor element, whereas the second electrode is located in vicinity to the lower side of the semiconductor element. In detail, the power semiconductor element is arranged between the first electrode and the second electrode such, that the upper side is in electrical contact to the first electrode. Correspondingly, the lower side is in electrical contact to the second electrode. This electrical contact may thereby be formed directly or indirectly, via another electrically conductive part or layer, respectively.

Further, a housing arrangement is provided in order to airtightly enclose and hermetically seal the semiconductor element. This may be advantageous in order to ensure that the power semiconductor element works properly. The housing arrangement may at least comprise, or may be formed from an insulating shell particularly in a ring form which at least partly is located adjacent to the electrodes. Further, the electrodes may be part of the housing arrangement. Apart from that, one or more flanges may be provided which connect the electrodes with the insulator in order to close the housing. Thus, the flange or the flanges may as well form part of the housing arrangement. As such, the housing arrangement may form a press-pack type housing.

In case the power semiconductor element has a failure, there is the danger of a plasma to be formed in vicinity to the semiconductor element and thus inside the housing arrangement. This may in an especially intense manner be the case insofar PN-junctions are located at a free portion not being in direct contact with the respective electrode. In this case, a significant overpressure may occur which potentially has the danger of negatively influencing the parts of the semiconductor device.

In order to reduce the danger based on an overpressure to be formed, at least one safety element comprising a porous material or consisting of a porous material is provided inside the housing arrangement. With this regard, the power semiconductor device may comprise one or more safety elements which all may be formed correspondingly according to the embodiments as described below, or they may be formed in any combination of the below-described embodiments.

The provision of such one or more safety elements having a porous material inside the housing arrangement provides significant advantages over the solutions of the prior art. A safety element in the light of the present invention is thus an element which acts against a rupture or an explosion, respectively, of the housing arrangement and thus provides an improved safety.

In fact, due to the provision of a safety element having a porous material, the safety element may effectively work as a plasma absorbing part and as an energy absorbing part which already as a standalone measure significantly reduces the danger of a rupture of the housing arrangement. Due to the provision of a porous material, the latter may thus in a significant manner absorb a plasma formed and/or energy formed during a failure mode and may thus significantly lower the danger of the housing element to be ruptured.

Due to the very large surface area of the porous material, the safety element can effectively cool the arc plasma by absorbing a great amount of hot particles and the corresponding thermal energy from the plasma, preventing the deposition of this energy in the sensitive housing parts and in pressure-developing polymers, in case they are present inside the housing.

Because of the porous structure, the safety element can absorb mechanical energy very well, reducing the impact of the pressure wave generated by the electric arc on the surrounding parts. This will further significantly reduce the risk of deformation and/or rupturing of these parts.

Regarding the porosity provided, even though an open porosity may be advantageous, it is generally part of the invention to use closed porosity. Advantageous porosities may in a non-limiting manner lie in a range of equal to or more than 50% to equal to or smaller than 90% of gas in the volume. The degree of porosity in % may be measured by industrial computed tomography (CT) scanning, for example. Further, advantageous porosities may lie in the range of equal to or more than 20 ppi to equal to or smaller than 100 ppi (pores per inch, according to the American standard ASTM D3576-77).

Apart from the above, the safety element may be integrated into the housing even in case the housing has a limited mounting volume only due to the fact that the safety element may be tailored to the existing dimensions in an easy manner during its production method. The respective form and dimension of the safety element, or the porous material, respectively, is generally not limited so that tailoring the safety element to the desired application and requirements is well possible. This allows an easy and effective adaption to the respective requirements as well as properties of the power semiconductor device. The safety element may thereby also allow complying with the hermeticity requirements for press-pack housings as the structure of the housing arrangement is not negatively influenced.

The absorption of energy may further be realized in a very fast timescale thus allowing a very dynamic response behaviour which in turn allows a high safety measure.

Apart from that, the power semiconductor element allows an improvement of the failure mode without opening the housing arrangement which in turn allows a safety improvement for surrounding personnel as well as components.

As a result, the present invention effectively addresses the problem according to which explosions of semiconductor devices can cause damage to equipment or injuries to personnel and in contrast thereto, these problems are securely avoided or at least significantly reduced.

Devices with the above-described safety element have a higher case-non-rupture capability or, in other words, may sustain higher current integrals without explosive rupturing of the device and release of conductive plasma. This is particularly important for fault situations where the device has to sustain multiple current half waves before the fault is cleared and the pressure inside the housing further increases with each half wave.

Devices with case-non-rupture capabilities in excess of current integrals of 100MA²s are under circumstances requested in the present field of technique, as they allow saving expensive semiconductor fuses in certain applications. This is above the rupture limit of a plurality of current state-of-the-art devices but may particularly be achieved according to the present invention.

To summarize, a solution to improve the case-non-rupture capability of press-pack housings for bipolar power semiconductors is provided, preventing the power semiconductor device from explosion in the failure mode in a large range. Thus, the danger of damaging parts in the vicinity of the power semiconductor device is reduced. As a result, the safety is significantly improved. This will improve the safety of converter installations using such devices, by preventing damage both to surrounding equipment and operating personnel in the event of critical short-circuit failures.

In the following, further embodiments of the power semiconductor device are described, which may each or in every combination form an aspect of the present invention.

According to an embodiment, at least one safety element comprises a foam as porous material. Especially a foam as porous material comprises a very large surface area per weight so that the safety element especially effectively absorbs energy. Therefore, especially when using a foamed material, the non-rupture capability may be especially significantly enhanced.

Apart from that, foamed materials as such are known from different fields of technique very well, so that they may be formed in an especially defined way regarding porosity as well as geometry and dimensions and furthermore very cost-saving. As a result, foams allow the effect of the safety element to be tailored in a defined way according to the respective requirements because of which an appropriate safety improvement may be reached for different applications and requirements.

According to a further embodiment, the porous material is formed from a metal material or from a ceramic material. According to this embodiment, especially advantageous properties of the safety element may be reached. Especially, such foams may provide a good long term stability for working conditions in a power semiconductor device and further have especially effective energy absorbing properties allowing a significant safety enhancement.

Further, this embodiment may under circumstances be especially advantageous in case the metal material or the ceramic material is formed as a foam.

With regard to ceramic foams, for instance, such materials are produced in large quantities and are available at small prices and from different well-known suppliers. Commonly available materials which are usable according to the present invention are Al₂O₃, SiC, and ZrO. Porosities typically range from equal to or more than 10 ppi to equal to or less than 80 ppi and/or a solid content of equal to or more than 10% to equal to or less than 50% leading to a gaseous content of equal to or more than 50% to equal to or less than 90%. To produce a ceramic foam part, a plastic foam is soaked with a ceramic suspension, followed by drying and sintering of the material, as it is generally known in the art. Therefore, any shape of the ceramic foam that can be produced from plastic foam can be easily manufactured.

Further, ceramic foams show good insulation properties. This effect may be advantageous in dependence of the respective embodiment.

Regarding a metallic foam, these materials are also available from several well-known suppliers and may comprise metals or metal alloys. Available materials include copper, aluminium and nickel or nickel alloys. The relative density of as-manufactured metal foams is on the order of 10%, and porosities range between equal to or more than 10ppi to equal to or less than 60ppi, but the metal foams can also be compressed to achieve higher densities and smaller pore sizes. Metal foams are generally known in the field of light-weight construction, for example and can as well be formed as it is generally known in the art, e.g., by casting a replica of a polyurethane foam skeleton or by powder metallurgy processes.

Further, a metal foam can be used as a very efficient plasma- and energy-absorbing material, which has a an especially good thermal as well as electrical conductivity and further good sticking coefficients for the adsorption of metal ions. Therefore, depending on the application, a porous metal material may be preferred.

According to a further embodiment at least one safety element is formed in a ring structure. This embodiment allows an especially secure arrangement due to the fact that independently of the position of the electric arc, the safety element is in close proximity thereto. Therefore, the non-rupture capability may be significantly improved. The ring structure may for example be arranged such, that it at least partly surrounds the power semiconductor element and is arranged adjacent to a ceramic ring structure of the housing arrangement, thereby having the capability of especially effectively reducing the danger of a rupture.

Next to the above-described advantages, a ring structure may be implemented into existing housing designs especially easily due to the fact that mostly no intense changes in the specifications of the housings and the internal structure are required. Therefore, such a safety element may be implemented into existing production processes without significant problems.

According to a further embodiment, a further safety element is provided, the further safety element being formed as a ring structure formed from a polymeric material, such as from PTFE. Correspondingly to the safety element as described above, the polymeric ring may advantageously be inserted into the volume between the particularly ceramic insulator of the housing element and the power semiconductor element. According to this embodiment, the non-rupture capability of the power semiconductor device may further be enhanced. In detail, hot plasma may further be prevented from reaching an insulating part, such as a ceramic ring of the housing or flanges provided. This safety element thus may additionally to the porous material parts effectively act as a barrier for the hot plasma. The polymeric ring structure may thus additionally help to even more prevent explosion.

Exemplarily, it may be especially advantageous that the polymeric ring is located directly adjacent to an insulator, such as a ceramic ring structure, of the housing arrangement, and that the porous material essentially fully fills the free volume being provided between the polymeric ring and the power semiconductor element.

Apart from that, due to the provision of a polymeric ring structure in combination with the porous material, the porous material may, depending on the respective positions of the safety elements, confine the arc plasma and prevent radiation impact on the pressure-developing polymer. Therefore, a property of the polymeric ring structure which provides disadvantages in prior art solutions may be damped significantly especially in case at least one safety element comprising the porous material may be arranged at least partly between the power semiconductor device and the safety element having the polymeric ring.

According to a further embodiment, at least one safety element having a porous material is formed in a two-part form. This embodiment provides a safety element which may comprise two interlocking porous parts, such as ceramic foam rings, that fill almost the entire arcing volume. The two interlocking parts have the advantage that the entire arcing volume can be filled and the device may still be assembled in a straightforward manner.

According to a further embodiment, at least one safety element being formed from a ceramic material is at least partly surrounded by a metallic support. The metallic support may thereby be formed from one or a plurality of parts and/or may surround the ceramic foam at the upper side and the lower side, respectively. This embodiment may as well provide a safety element which may comprise a ceramic material, such as a ceramic foam ring, that particularly protect the insulating ceramic wall of the housing from direct plasma impact. Further, two parts of the metal supports are provided, which may be in direct contact with the porous ceramic material and which may be formed as support rings and may be porous such as foams, or not. The metallic support may protect the upper and lower flange regions above and below the insulation part of the housing arrangement, i.e. the flange regions, preventing a direct impact of the arc plasma on the sensitive flange parts. The metallic support or the parts thereof could be integrated into the pole pieces, i.e. the electrodes, as well. According to this embodiment, not only the insulator of the housing arrangement is well protected, but also the flanges between the insulator and the electrodes are protected in a secure manner, further reducing the danger of a rupture of the housing arrangement to occur.

According to a further embodiment, at least one safety element comprising a ceramic material is provided and additionally a safety element comprising a metallic material is provided.

According to this embodiment, a safety element may comprise or consist of a ceramic foam ring and a metal foam ring that fills the arcing volume enclosed by a plastic protection ring. An advantage of such a combination of a ceramic foam and a metallic foam can be seen in the fact that ceramic foam filling the entire volume may under circumstances be less effective, metal foam filling the entire volume is, however, possible in a limited manner, only, because electrical insulation is needed at some positions. The ceramic foam ring may thus ensure the necessary air strike distance between metal parts at different potential. The metal foam, on the other hand, may have advantageous properties as plasma-and energy-absorbing material, such as an especially good thermal as well as electrical conductivity and good sticking coefficients for the adsorption of metal ions.

### Brief Description of Drawings

These and other aspects of the invention will be apparent from and elucidated with reference to the embodiments described hereinafter.

In the drawings:
- Fig. 1: shows a part of an exemplary embodiment of a power semiconductor device according to the invention;
- Fig. 2: shows an embodiment of a safety element for using in a power semiconductor device according to the invention;
- Fig. 3: shows a part of a further embodiment of a power semiconductor device according to the invention;
- Fig. 4: shows a part of a further embodiment of a power semiconductor device according to the invention;
- Fig. 5: shows a part of a further embodiment of a power semiconductor device according to the invention; and
- Fig. 6: shows a part of a further embodiment of a power semiconductor device according to the invention.

### Detailed Description of the Invention

Reference will now be made in detail to various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

Within the following description of the drawings, the same reference numbers refer to the same components. Generally, only the differences with respect to the individual embodiments are described. When several identical items or parts appear in a figure, not all of the parts have reference numerals in order to simplify the appearance.

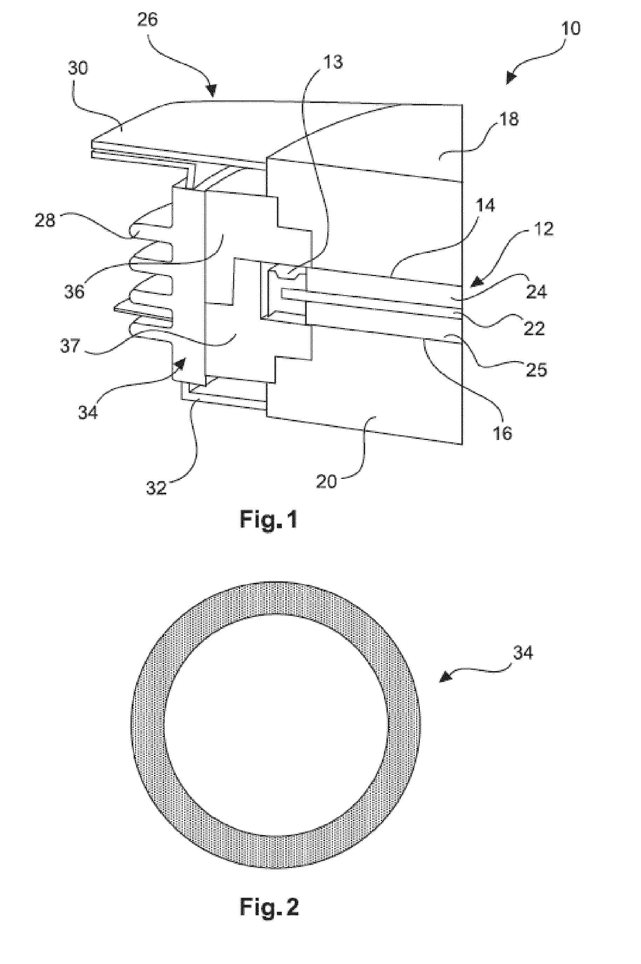

In figure 1, a cross-section of a part of an embodiment of a power semiconductor device 10 according to the present invention is shown. The power semiconductor device 10 may comprise a power GTO or IGCT, IGBT, diode or a thyristor, for example and may have a press-pack housing.

The power semiconductor device 10 particularly is a bipolar power semiconductor device and has an enhanced explosion withstand capability and is thus capable of withstanding even high failure current integrals. This will improve the safety of converter installations using such devices 10, by preventing damage both to surrounding equipment and operating personnel in the event of critical short-circuit failures.

With this regard, the power semiconductor device 10 comprises a power semiconductor element 12 with an upper side 14 and with a lower side 16, the upper side 14 being located opposite to the lower side 16. It is further shown that the power semiconductor element 12 comprises a silicon layer 22 such as a silicon pellet exemplarily containing a thyristor device.

Further, a first electrode 18 and a second electrode 20 are shown between which the power semiconductor element 12 is clamped, which may be called a free-floating arrangement. The silicon pellet 22 containing the power semiconductor device may be encapsulated around its periphery by a rubber protection layer 13. The first electrode 18 and the second electrode 20 may be formed from copper, for example. The power semiconductor element 12 may for example be arranged between the first electrode 18 and the second electrode 20 such, that it is integrated between two molybdenum layers 24, 25 to reduce the mechanical stress on the silicon layer 22 caused by mismatch of the coefficients of thermal expansion.

Further, a housing arrangement 26 is provided for hermetically sealing the power semiconductor element 12 from the surrounding atmosphere, the housing arrangement 26 comprising the first electrode 18, the second electrode 20 and an electrical insulator 28, which may be formed for example from a ceramic material and has the form of a ring. Further an upper flange 30 and a lower flange 32 are provided in order to hermetically close and seal the housing arrangement 28 particularly between the electrodes 18, 20 and the insulator 28. Thus, the contact pole pieces, or electrodes 18, 20, respectively, are connected to the particularly thin and flexible flanges 30, 32, which may be formed from copper, wherein the flanges 30, 32 are connected to the insulating ceramic cylinder and thus the insulator 28 that forms the side walls of the press-pack housing arrangement 26, yielding a hermetically sealed housing.

It can further be seen, that a safety element 34 is provided. The safety element 34, according to figure 1, consists of a porous material, which may for instance be a ceramic foam or a metallic foam having an especially high surface area. According to figure 1, the safety element 34 is formed in a two parts structure and comprises two interlocking ring-like parts 36, 37. The safety element 34 essentially fills the whole free volume being positioned between the housing arrangement 28 and the power semiconductor element 12.

The above arrangement allows providing press-pack housings with higher case-non-rupture ratings, as the safety elements may confine the arc plasma and absorb energy from the arc without causing excessive pressure development.

In other words, power semiconductor devices 10 with a safety element 34 according to the present invention show higher case-non-rupture capability than state-of-the-art solutions. Depending on the used embodiment, such devices are able to withstand about 50% higher current pulses without housing rupture than samples with identical design but without the porous safety elements 34.

Figure 2 shows a safety element 34 which is formed in a ring structure and which consists of a ceramic foam. Such a safety element 34 is a non-limiting example and may be easily tailored to the desired application and may be positioned surrounding the power semiconductor element 12 and inside the ceramic insulator 28.

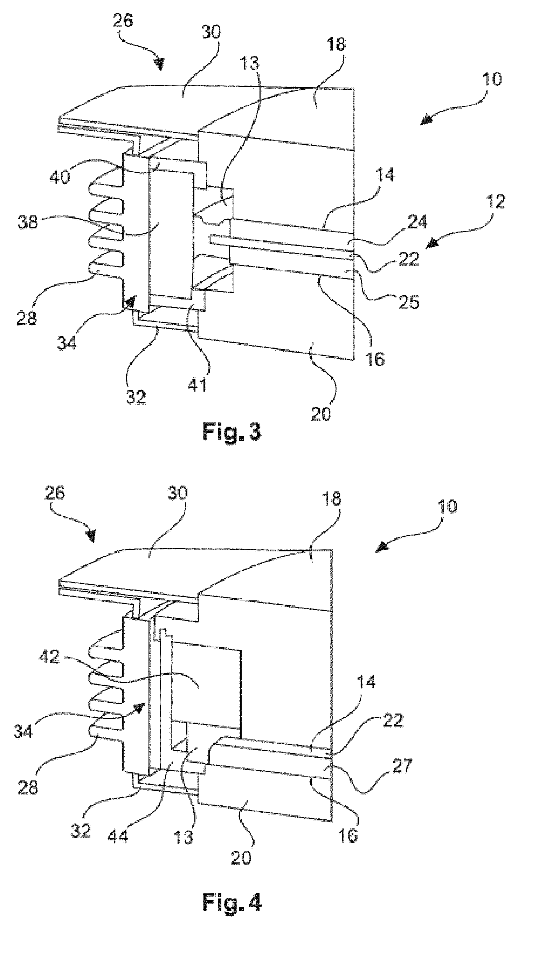

In the following, figures 3 to 6 show further embodiments of power semiconductor devices 10 according the invention in which particularly the safety element 34 is changed. With regard to the further features, it is referred to the description of figure 1.

With regard to figure 3, the safety element 34 of this embodiment comprises a ceramic foam ring 38 that protects the ceramic insulator 28 of the housing arrangement 26 from direct plasma impact, and further a metallic support comprising two metallic support rings 40, 41, that protect the regions of the upper flange 30 and lower flange 32.

Regarding figures 4 to 6, the power semiconductor element 12 is shown in different manner, which, however, is generally freely exchangeable with regard to the power semiconductor element 12 described with regard to figures 1 and 3 and vice versa. With regard to figures 4 to 6, the silicon layer 22, or silicon wafer, respectively, may be bonded to a molybdenum support 27, which may be thicker compared to the layers 24, 25, preferably on the anode side, or bottom side, respectively.

In figure 4, it can further be seen, that adjacent to the ceramic insulator 28, a further safety element 44 being formed as a ring structure formed from a polymeric material is provided as additional safety measure. The safety element 34 comprises according to figure 4 a ceramic foam ring 42, for example as shown in figure 2, filling the arcing volume enclosed by said safety element 44 formed as a polymeric plastic protection ring.

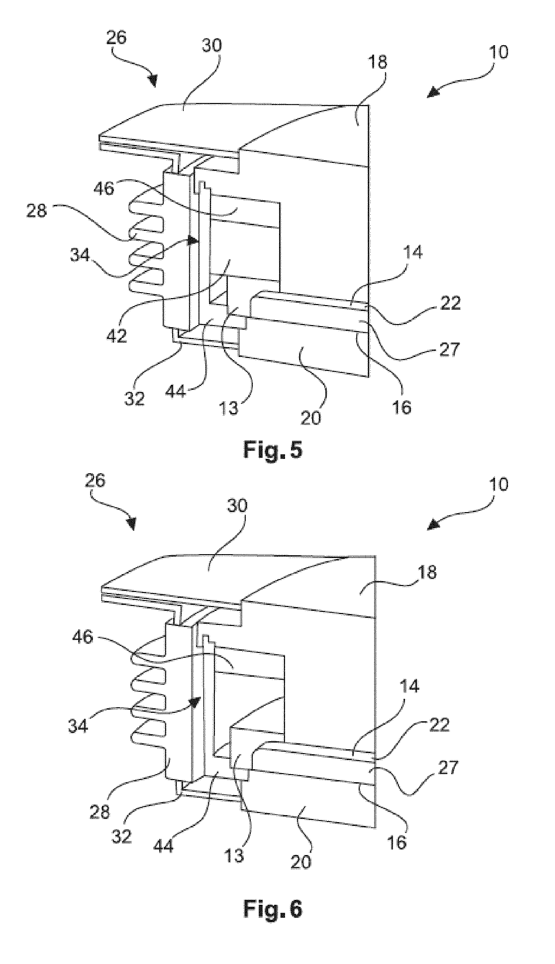

With regard to figure 5, according to this embodiment, the safety element 34 consists of a ceramic foam ring 42 like described above and a metal foam ring 46 that fills the arcing volume enclosed by the plastic protection ring as safety element 44. The ceramic foam ring 42 ensures the necessary air strike distance between metal parts at different potential.

Regarding figure 6, the safety element 34 consists of a metal foam ring 46 filling the upper part of the arcing volume enclosed by the plastic protection ring as safety element 44. The metal foam ring 46 can be fixed by any means to the upper pole piece part, such as by gluing, brazing, clamping, etc.

While the invention has been illustrated and described in detail in the drawings and foregoing description, such illustration and description are to be considered illustrative or exemplary and not restrictive; the invention is not limited to the disclosed embodiments. Other variations of the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 10: power semiconductor device
- 12: power semiconductor element
- 13: protection layer
- 14: upper side
- 16: lower side
- 18: first electrode
- 20: second electrode
- 22: silicon layer
- 24: molybdenum layer
- 25: molybdenum layer
- 26: housing arrangement
- 27: molybdenum support
- 28: electrical insulator
- 30: upper flange
- 32: lower flange
- 34: safety element
- 36: ring-like part
- 37: ring-like part
- 38: ceramic foam ring
- 40: metallic support ring
- 41: metallic support ring
- 42: ceramic foam ring
- 44: safety element
- 46: metallic foam ring

## Claims

1. Power semiconductor device (10), comprising
a power semiconductor element (12) with an upper side (14) and with a lower side (16), the upper side (14) being located opposite to the lower side (16);
a first electrode (18) and a second electrode (20), wherein
the power semiconductor element (12) is arranged between the first electrode (18) and the second electrode (20) such, that the upper side (14) is in electrical contact to the first electrode (18), and that the lower side (16) is in electrical contact to the second electrode (20), and wherein a
housing arrangement (26) is provided at least comprising the first electrode (18), the second electrode (20) and an electrical insulator (28), wherein at least one safety element (34) comprising a porous material is provided inside the housing arrangement (26).

2. Power semiconductor (10) device according to claim 1, wherein the at least one safety element (34) comprises a foam as porous material.

3. Power semiconductor device (10) according to claim 1 or 2, wherein the porous material is formed from a metal material or from a ceramic material.

4. Power semiconductor device (10) according to any of the preceding claims, wherein at least one safety element (34) is formed in a ring structure.

5. Power semiconductor device (10) according to any of the preceding claims, wherein a further safety element (44) is provided, the further safety element (44) being formed as a ring structure formed from a polymeric material.

6. Power semiconductor device (10) according to claim 5, wherein at least one safety element (34) comprising the porous material is arranged at least partly between the power semiconductor device (12) and the safety element (44) being formed as a ring structure formed from a polymeric material.

7. Power semiconductor device (10) according to any of the preceding claims, wherein at least one safety element (34) having a porous material is formed in a two-part form.

8. Power semiconductor device (10) according to any of the preceding claims, wherein at least one safety element (34) being formed from a porous ceramic material is at least partly surrounded by a metallic support.

9. Power semiconductor device (10) according to any of the preceding claims, wherein at least one safety element (34) comprising a porous ceramic material is provided and wherein additionally a safety element (34) comprising a porous metallic material is provided.

10. Power semiconductor device (10) according to any of the preceding claims, wherein the power semiconductor element (12) comprises a thyristor or a diode.
